# EUROPÄISCHE PATENTSCHRIFT

(11) **EP 3 576 508 B1**
(45) Veröffentlichungstag und Bekanntmachung des Hinweises auf die Patenterteilung: **09.12.2020**
(21) Anmeldenummer: 19020354.7
(22) Anmeldetag: 29.05.2019
(51) Int. Cl.: H05K 7/14, H01Q 1/22, H04B 1/38, H04W 4/80

(54) **ANSCHLUSSMODUL MIT OPTISCHER SCHNITTSTELLE ZUR AKTIVIERUNG EINES FUNK-SENDERS/EMPFÄNGERS UND VERFAHREN SOWIE HERSTELLUNGSVERFAHREN HIERZU**
CONNECTION MODULE WITH OPTICAL INTERFACE FOR ENABLING A WIRELESS TRANSMITTER/RECEIVER AND METHOD AND CORRESPONDING PRODUCTION METHOD
MODULE DE RACCORDEMENT POURVU D'INTERFACE OPTIQUE PERMETTANT D'ACTIVER UN ÉMETTEUR / RÉCEPTEUR RADIO ET PROCÉDÉ AINSI QUE PROCÉDÉ DE FABRICATION CORRESPONDANT

(30) Priorität: 29.05.2018 DE 102018004272
(43) Veröffentlichungstag der Anmeldung: 04.12.2019
(73) Patentinhaber: Hilscher Gesellschaft Für Systemautomation MBH, 65795 Hattersheim (DE); Hilscher, Hans Jürgen, 65795 Hattersheim (DE)
(72) Erfinder: Hilscher, Hans-Jürgen, D-65795 Hattersheim (DE)
(74) Vertreter: Dreykorn-Lindner, Werner

(56) Entgegenhaltungen:
- WO-A1-2015/150402
- DE-A1-102009 044 046
- DE-A1-102012 106 923
- DE-U1-202009 009 066

## Beschreibung

Die Erfindung betrifft, gemäß Patentanspruch 1, ein Anschlussmodul mit einem aktivierbaren und de-aktivierbaren Funk-Sender/Empfänger als drahtlose Schnittstelle zur Diagnose und Konfiguration des Geräts. Weiterhin betrifft die Erfindung, gemäß Patentanspruch 11, ein Verfahren zur Aktivierung eines Funk-Senders/Empfängers für ein Anschlussmodul gemäß Anspruch 1. Schließlich betrifft Anspruch 15 ein Verfahren zur Herstellung eines Anschlussmoduls.

Die kontinuierliche voranschreitende Vernetzung der Produktion führt dazu, dass Maschinen mit immer mehr Sensoren ausgerüstet werden. Der Anstieg an Sensoren und Aktoren und dem daraus resultierenden Anstieg an Verkabelung führt jedoch zum Problem, dass die Wartung, Fehleranalyse und Installation von kabelgebundenen Sensoren immer komplizierter wird.

Aus der DE 102 32 660 A1 ist eine Betätigungsvorrichtung für eine Peripherie-Baugruppe mit zumindest einem Sensoranschluss bekannt, die mit gängigen Mitteln eine schnelle und einfache Verbindung zu dem Sensoranschluss ermöglicht. Hierzu ist vorgesehen, dass zumindest ein erstes Betätigungselement mit einem damit in Verbindung stehenden mit dem Sensoranschluss kompatibel ausgebildeten Anschlusselement vorgesehen ist. Im Einzelnen weist die Betätigungsvorrichtung eine steckbare und/oder schraubbaren Ausgestaltung, insbesondere ein Anschlusselement mit einem ersten und zweiten Bereich mit einem M8, M10- oder M12 Gewinde für den Sensoranschluss auf. Die Betätigungsvorrichtung bzw. das zugehörige im Wesentlichen zylinderförmige Gehäuse sind gekapselt und/oder abgedichtet und/oder berührungssicher ausgestaltet, so dass Kriterien für Schutzarten, insbesondere IP 65 oder IP 67 und/oder Schutzklassen eingehalten werden können. Die Betätigungselemente sind als Schalter, insbesondere als Kipp-, Druck-, Schiebe-, Dreh-, Opto- oder Sensorschalter bzw. als Taster ausgestaltet. Dadurch kann die Betätigungsvorrichtung während des Betriebs - ohne eine Spannungsfreischaltung der entsprechenden Peripherie-Baugruppe - für einen temporären, sensorfreien, bzw. dauerhaften Einsatz abgenommen bzw. aufgesetzt werden. Insbesondere kann die Betätigungsvorrichtung zu Testzwecken als anbringbare oder abnehmbare modulartige Prüfvorrichtung eingesetzt werden, wobei mit einer Betätigungsvorrichtung mehrere Peripherie-Baugruppen eingerichtet, geprüft, in Betrieb genommen oder gewartet werden können. Die über den Sensoranschluss einer Peripherie-Baugruppe zugänglichen Digitaleingänge sind auf diese Weise unabhängig von einer Anlagenverdrahtung schnell und einfach ohne weitere Mittel, wie beispielsweise einem Zusatzsensor, aktivier- bzw. deaktivierbar.

Weiterhin ist aus der DE 10 2008 042 314 B4 ein Messumformer zur Verbindung eines Sensorelements mit einer externen Einheit, insbesondere einer Anzeige- oder Steuerungseinheit, bestehend aus einem Gehäuse, an dem zwei normierte Steckverbinder vorgesehen sind, bekannt. Der erste Steckverbinder dient als Sensoranschluss und der diesem diametral gegenüberliegende zweite Steckverbinder als Kommunikations- und/oder Energieversorgungsanschluss. Im Inneren des Gehäuses des Messumformers ist eine Sensorelektronik angeordnet, die zur Auswertung von über den Sensoranschluss gelieferten Sensorsignalen und zur Kommunikation mit der externen Einheit dient. Im Einzelnen ist die Sensorelektronik auf einem Leiterplattenstapel mit Leiterplatten angeordnet, wobei die jeweils den Leiterplatten zugewandten Anschlussseiten der beiden Steckverbinder vollständig in die Kontur des Leiterplattenstapels hineinragen. Weiterhin weisen die beiden Steckverbinder jeweils eine Überwurfmutter auf, die als Sechskant oder als Rändelmutter ausgeführt ist und die unmittelbar am Gehäuse anliegt, und die Außenkontur des Gehäuses wird durch die Kontur des Leiterplattenstapels bestimmt. Der Messumformer weist im Innern des Gehäuses ein Anzeigeelement auf, bspw. eine oder mehrere LED, welche dem Anwender z.B. über bestimmte Betriebszustände oder über das Anliegen einer Betriebsspannung informieren. Oftmals ist von außen schlecht zu erkennen, ob die LED leuchtet, insbesondere, wenn man sich in einer hellen Umgebung befindet. Aus diesem Grund kann das Messumformer-Gehäuse derart ausgestaltet sein, dass die LED nur in einem aktiven Zustand, d. h. wenn die LED leuchten, zu sehen sind. Hierfür ist das Gehäuse, insbesondere im Bereich der LED, transparent oder transluzent. Aufgrund des dadurch besseren Kontrastes wird das Ablesen bzw. Erkennen einer leuchtenden LED verbessert.

Weiterhin ist aus der DE 101 04 422 A1 ein Sensorgehäusesystem mit einem zumindest abschnittsweise zylindrischen Gehäuse bekannt, welches in eine zylindrische Hülse mit Außengewinde einsteckbar ist, wobei eine drehbeweglich am zumindest abschnittsweise zylindrischen Gehäuse befestigte Überwurfmutter mit dem Außengewinde der zylindrischen Hülse verschraubbar ist. Nach dem Aufschrauben der Überwurfmutter ist die mechanisch robuste Konfiguration (Rüttelfestigkeit) des Sensors sichergestellt. Die zylindrische Hülse mit Außengewinde dient zur Aufnahme des zumindest abschnittsweise zylindrischen Gehäuses des Sensors und gleichzeitig zur mechanischen Fixierung im konkreten Anwendungsfall, beispielsweise durch Einschrauben in eine Gewindebohrung eines Maschinen- oder Anlagenteils. Das Sensorgehäusesystem setzt sich somit zusammen aus dem zylindrischen Gehäuse - vorzugsweise aus einem Kunststoff - und der teilweise über dieses zylindrische Gehäuse gesteckten zylindrischen Hülse - vorzugsweise aus einem Metall (Edelstahl) - mit Außengewinde. Der Gewindedurchmesser der zylindrischen Hülse beträgt beispielsweise MS8 M12, M18 oder M30, jeweils abhängig vom Sensortyp. Der der obere Rand der zylindrischen Hülse ist mit einer Vielzahl von Kerben versehen, welche jeweils gleichen Abstand voneinander aufweisen, um derart eine Fixierung des Sensors in einer gewünschten Position zu realisieren. Bei einem Abstand von jeweils 15° ergeben sich beispielsweise vierundzwanzig Kerben. Am umlaufenden Rand des zylindrischen Gehäuses befindet sich mindestens eine Nase. Formgebung von Nase und Kerben sind aneinander angepasst, so dass die Nase in eine der Kerben eingreifen kann, wodurch eine relative Drehbeweglichkeit zwischen zylindrischem Gehäuse und zylindrischer Hülse unterbunden wird. Nach Festziehen der Überwurfmutter am Außengewinde der zylindrischen Hülse ergibt sich eine Schraubverbindung zwischen zylindrischem Gehäuse und zylindrischer Hülse, welche weder drehbeweglich noch längsverschieblich ist. Neben der vorstehend beschriebenen drahtgebundenen Ausgestaltung ist das Sensorgehäusesystem auch für drahtlose Sensoren, beispielsweise drahtlosen Näherungssensoren geeignet. Haukomponenten bestimmt. Das Sensorgehäusesystem setzt sich zusammen aus einem zylindrischen Gehäuse, einem Elektronikabschnitt und einer teilweise über das zylindrische Gehäuse gesteckten zylindrischen Hülse mit Außengewinde. Zylindrisches Gehäuse und Elektronikabschnitt können einstückig oder mehrstückig (modular) ausgebildet sein. Bei mehrstückiger Ausbildung sind die einzelnen Teilkomponenten über eine elektrische Steckvorrichtung zusammengesteckt. Der Elektronikabschnitt enthält bei einem drahtlosen Näherungssensor vorzugsweise alle Komponenten mit Ausnahme des die Sensorumgebung detektierenden Sensorkopfes, d. h. der Elektronikabschnitt enthält eine zur Auswertung des Sensorsignales erforderliche Sensorsignal-Auswerteeinheit, einen zur Umwandlung des ausgewerteten Sensorsignales erforderlichen Modulator/Codierer und einen zur Abstrahlung von Funksignalen dienenden Sender mit Antenne. Zweckmäßig enthält der Elektronikabschnitt darüber hinaus auch einen Funkempfänger zum Empfang von Parametersätzen (Sensor-Schaltschwellen, Schalthysteresen, Korrekturfaktoren für unterschiedliche zu identifizierende Materialien, vorgegebene Entfernungsbereiche zwischen Sensor und zu identifizierendem Objekt) und einen nachgeschalteten Demodulator/Decodierer zur Aufbereitung des empfangenen Signals und Speicherung sowie Zufuhr zur Sensorsignal-Auswerteeinheit. Des Weiteren enthält der Elektronikabschnitt eine zur kabellosen Energieeinspeisung und -Versorgung erforderliche Einheit. Die Vorteile bestehen insbesondere darin, dass sich der Sensor nach dem Lockern der Überwurfmutter drehen lässt, um beispielsweise eine Anzeige des Sensors optisch zugänglich zu machen oder um die Empfangs/Sende Verhältnisse bei einem drahtlosen Sensor zu verbessern, ohne dass dabei eine erneute mechanische Justierung des Sensors erfolgen muss. Des Weiteren kann ein defekter Sensor durch bloßes Lösen der Überwurfmutter in sehr einfacher Weise ausgetauscht werden. Der Ersatzsensor muss lediglich in die am Anlagen- oder Maschinenteil montierte und justierte zylindrische Hülse eingeführt und mit seiner Überwurfmutter befestigt werden. Die einmal eingestellte Justierung bleibt vielmehr auch beim Sensorwechsel erhalten. Das Sensorgehäusesystem kann insbesondere auch bei einem Industrieroboter, einem Fertigungsautomaten, einem Herstellungsautomaten oder einem Automationssystem verwendet werden, welcher bzw. welches eine Vielzahl von Näherungssensoren/Näherungsschaltern (System) mit unterschiedlichen Befestigungsöffnungen aufweist, wobei eine Funkübertragung zwischen den einzelnen Näherungssensoren und einer Zentralstation mit angeschlossenem Prozessrechner zur Übermittlung der Sensorsignale und gegebenenfalls zur Übermittlung von Parametersätzen vorgesehen ist.

Weiterhin ist aus der EP 3 293 588 A1 ein Verfahren zur Konfiguration von Raumautomationskomponenten eines Gebäudeautomationssystems während einer Installations- und Konfigurationsphase bekannt. Dabei wird zur Konfiguration in einer Installationsphase von einer- meist zentralen - Konfigurationseinheit des Gebäudeautomationssystems jeder Raumautomationskomponente eine eindeutige, temporäre Adresse zugeordnet wird. Zusätzlich wird für jede Raumautomationskomponente und die jeweils zugehörige temporäre Adresse ein eindeutiger Erkennungscode definiert und an die jeweilige Raumautomationskomponente übermittelt. Nach der Installation bzw. Montage der Raumautomationskomponenten wird das Gebäudeautomationssystem zur Gänze oder teilweise in einen Konfigurationsmodus versetzt und im Konfigurationsmodus werden die jeweiligen installierten Raumautomationskomponenten angewiesen, ihren jeweiligen Erkennungscode auszusenden. Der jeweilige Erkennungscode der jeweiligen Raumautomationskomponente wird mit Hilfe einer mobilen Einheit ermittelt und an die Konfigurationseinheit zur Identifikation weitergeleitet. Dabei ist eine eindeutige Identifikation der jeweiligen Raumautomationskomponente und dem zugehörigen eindeutigen Erkennungscode durch die mobile Einheit erforderlich. Nach einer erfolgreicher Identifikation und Assoziation mit der zugehörigen temporären Adresse wird die jeweilige identifizierte Raumautomationskomponente auf der mobilen Einheit gekennzeichnet und kann dann für die weitere Konfiguration ausgewählt werden. Weiterhin kann vorgesehen sein, dass der jeweilige eindeutige Erkennungscode von der jeweilige Raumautomationskomponente als optisches Signal und/oder als Nahfeld-Funksignal bzw. als Funksignal mit sehr eingeschränkter Reichweite ausgesendet wird, um die eindeutige Identifikation der jeweiligen Raumkomponente zu ermöglichen. Je nach Ausgestaltung der jeweiligen Raumautomationskomponente oder ihrer Montageposition kann der Erkennungscode von dieser Komponente entweder als optisches Signal oder als Nahfeld-Funksignal oder optisches Signal und als Funksignal in der Konfigurationsphase ausgegeben werden. Bei Raumautomationskomponenten, welche mit einer Leuchteinheit ausgestattet sind (z.B. LED, Display mit Hintergrundbeleuchtung) oder welche mit einer Leuchteinheit interagieren (z.B. Aktor für Beleuchtungskörper), kann diese zugehörige, für eine operativen Betrieb notwendige Leuchteinheit für das Aussenden des Erkennungscodes als optisches bzw. Lichtsignal eingesetzt werden. D.h. die zur jeweiligen Raumautomationskomponente gehörende oder zugeordnete Leuchteinheit wird für die Ausgabe des Erkennungscodes als optisches Signal in der Konfigurationsphase genutzt. Alternativ oder zusätzlich, kann der jeweilige Erkennungscode als Nahfeld-Funksignal von der jeweiligen Raumautomationskomponente ausgesendet werden. Dabei ist wichtig, dass beim Empfang des Nahfeld-Funksignals durch die mobile Einheit eine Position des Senders bzw. der jeweiligen Raumautomationskomponente relativ genau festgestellt werden kann. Daher werden idealerweise für ein Aussenden des Nahfeld-Funksignals Technologien mit geringer Reichweite wie z.B. Radio-Frequency-Identification (RFID) oder Nahfeld-Kommunikation (NFC) verwendet. Für die Ausgabe des Erkennungscodes als Nahfeld-Funksignal wird dann ein zur jeweiligen Raumkomponente gehörender RFID-(Radio-Frequency-Identification)-Chip oder NFC-(Nahfeldkommunikations-)-Chip eingesetzt. Eine für die Aussendung des Erkennungscodes notwendige Aktivierung des RFID- bzw. NFC-Chips wird - wie beim Aussenden des Erkennungscodes als optisches Signal - durch die Konfigurationseinheit beim Start oder bei Aktivierung der Konfigurationsphase ausgelöst. Idealerweise werden Raumautomationskomponenten ohne zugehörige Leuchteinheit oder z.B. eingebaute oder verbaute Raumautomationskomponenten mit einem RFID- oder NFC-Chip versehen, um den Erkennungscode als Funksignal aussenden zu können. Für eine raschere und bessere Ermittlung des Erkennungscodes durch die mobile Einheit kann beispielsweise eine Raumautomationskomponente mit Leuchteinheit auch mit einem RFID- bzw. NFC-Chip versehen sein und den Erkennungscode zusätzlich als Funksignal zur mobilen Einheit aussenden. Als mobile Einheit kann ein mobiles Endgerät wie z.B. ein Smartphone oder ein Tablet-PC benutzt werden. ehe bzw. installierte Applikation eingesetzt. Damit können bereits bei einem Nutzer bzw. Monteur verfügbare mobile Endgeräte verwendet werden, wobei die für die Konfigurationsphase notwendige Applikation auf das jeweilige mobile Endgerät (z.B. Smartphone, Tablet-PC. etc.) geladen werden bzw. auf diesem installiert muss. Weiterhinweisen heutzutage gebräuchliche, mobile Endgeräte wie z.B. Smartphones, Tablet-PCs, etc. üblicherweise optische Sensoren zum Erfassen einer lokalen Umgebung bzw. zum Erfassen von optischen Signalen (z.B. Kamera) auf. Häufig sind moderne Smartphones mittlerweile auch mit einer Einheit für Nahfeldkommunikation und damit zum Erfassen von RFID-oder NFC-Chips ausgesendeten Funksignalen ausgestattet. Meist weisen mobile Endgeräte wie z.B. Smartphone oder Tablet-PC auch eine eingabefähige Anzeige - einen so genannten Touchscreen - auf, sodass auf sehr einfache Weise eine identifizierte Raumautomationskomponente für das weitere Engineering ausgewählt und dann sehr leicht eine Konfiguration der ausgewählten Komponente auf dem mobilen Endgerät durchgeführt werden kann, wobei durch das optische Feedback auf der Anzeige- und Eingabeeinheit der mobilen Einheit die Wahrscheinlichkeit einer Fehlkonfiguration reduziert werden kann. Für die Kommunikation der mobilen Einheit mit der Konfigurationseinheit, insbesondere die Übertragung des erfassten Erkennungscodes der jeweiligen Raumautomationskomponente und des entsprechenden Feedback bei erfolgreicher Identifikation und Konfiguration, wird eine drahtlose Kommunikationsverbindung genutzt, beispielsweise das so genannte Wireless LAN eingesetzt werden, welches auf vielen heutzutage gebräuchlichen mobilen Endgeräten verfügbar ist. Alternativ oder zusätzlich, kann für die drahtlose Kommunikationsverbindung auch Bluetooth verwendet werden.

Weiterhin ist aus der DE 10 2012 106 923 A1 eine Schaltvorrichtung mit einem Schaltgerät und einem Funkmodul und einer Deaktivierungsfunktion bekannt. Das Funkmodul ist dazu vorgesehen, eine Information über einen Betriebszustand des Schaltgerätes drahtlos abrufbar zur Verfügung zu stellen. Die Schaltvorrichtung zeichnet sich dadurch aus, dass die Schaltvorrichtung ein manuelles Betätigungselement umfasst, mittels dessen das Funkmodul physikalisch deaktivierbar ist. Über das Funkmodul kann eine Information über den Betriebszustand der Schaltvorrichtung drahtlos abrufbar zur Verfügung gestellt werden. Am Funkmodul kann ein Anzeigeelement in Form eines sogenannten Multicolor-LEDs vorgesehen sein, dessen Farbdarstellung in Abhängigkeit von einem Betriebsparameter des Schaltgeräts erfolgen kann.

Um eine Anzeigevorrichtung mit einer drahtlosen Schnittstelle vorzuschlagen, die zum Einsatz in einem vernetzten Steuerungssystem ausgebildet ist, ist in Weiterbildung hierzu aus der WO 2015/150402 A1 eine Anzeigevorrichtung mit einer drahtlosen Schnittstelle bekannt, über die eine Kommunikation zwischen der Anzeigevorrichtung und einem zur Kommunikation mit der Anzeigevorrichtung konfigurierten Gerät ermöglicht wird. Weiterhin ist eine Schnittstelle zu einem Bus-System eines vernetzten Steuerungssystems vorgesehen, wobei die Anzeigevorrichtung als Bus-Slave in dem Bus-System konfiguriert ist. Die Anzeigevorrichtung kann ein Mehrfarben-Anzeigeelement zum Anzeigen des Betriebszustands von mindestens einem Busteilnehmer aufweisen. Ein Kontroller ist zum Steuern des Mehrfarben-Anzeigeelements und zur Kommunikation über die drahtlose Schnittstelle und die Bus-System-Schnittstelle konfiguriert. Mit einer derartigen Anzeigevorrichtung, die als Busteilnehmer in ein vernetztes Steuerungssystem integriert ist und von einem Bus-Master angesprochen werden kann, wird mit der drahtlosen Schnittstelle ein flexibler Zugangspunkt zum vernetzten Steuerungssystem geschaffen, der es ermöglicht, über insbesondere mobile Kommunikationsgeräte wie einem tragbaren Computer, einem Tablet-PC, einem Mobiltelefon, einem Smartphone, einem PDA (Personal Digital Assistant) oder einer Datenbrille den Betriebszustand von einem oder mehreren Busteilnehmern anzeigen zu können. Während das Mehrfarben-Anzeigeelement ermöglicht, insbesondere sehr wichtige und binäre Informationen von Busteilnehmern ohne zusätzliche technische Hilfsmittel anzuzeigen, insbesondere den kritischen Betriebszustand eines Busteilnehmers beispielsweise durch ein bestimmtes Färb- und / oder Blinkmuster entsprechend optisch zu signalisieren, erlaubt die drahtlose Schnittstelle die Bereitstellung zusätzlicher komplexer Informationen über Busteilnehmer, vor allem auch über größere Distanzen, insbesondere die Übertragung von dem kritischen Betriebszustand eines Busteilnehmers entsprechende Daten an ein zur Kommunikation mit der Anzeigevorrichtung konfiguriertes Gerät zur Auswertung und Anzeige auf dem Gerät. Weiterhin können über die drahtlose Schnittstelle Befehle von dem zur Kommunikation mit der Anzeigevorrichtung konfigurierten Gerät empfangen werden, die in der Anzeigeeinrichtung beispielsweise zur Konfiguration des Mehrfarben-Anzeigeelements verarbeitet und / oder über die Bus-System-Schnittstelle an einen Bus-Master zur Verarbeitung übertragen werden. einen Bus-Master (24) zur Verarbeitung übertragen werden. Das Bus-System kann ein Feldbus-Bus nach dem Standard IEC 61 158 sein oder durch ein Industrial Ethernet implementiert sein. Der Kontroller kann konfiguriert sein, um Daten von mindestens einem Busteilnehmer über den Bus des Bus-Systems zu empfangen und über die drahtlose Schnittstelle an ein zur Kommunikation mit der Anzeigevorrichtung konfiguriertes Gerät zu übertragen. Der Kontroller kann zudem konfiguriert sein, um Daten von einer als Bus-Master konfigurierten Steuerungseinheit des vernetzten Steuerungssystems über den Bus des Bus-Systems zu empfangen und über die drahtlose Schnittstelle an ein zur Kommunikation mit der Anzeigevorrichtung konfiguriertes Gerät zu übertragen. Die Anzeigevorrichtung kann ein manuelles Betätigungselement aufweisen, das mit dem Kontroller verbunden ist und bei dessen Betätigung der Kontroller ein Flag setzt, das von einem Bus-Master ausgewertet werden kann, und/oder eine programmierte Funktion ausführt. Insbesondere kann der Kontroller bei Betätigen der Taste eine programmierte Funktion ausführen, wie beispielsweise ein Funkmodul zu (de)aktivieren, eine mehrfarbige Leuchtdiode abzuschalten oder in einen bestimmten Zustand zu schalten oder einen MCI-Bus-Slave in einen bestimmten Betriebsmodus zu schalten, wie beispielsweise Anzeige des generellen Betriebszustands des vernetzten Steuerungssystems. Die mehrfarbige Leuchtdiode kann in die Taste integriert sein, ebenso wie das Funkmodul. Das Funkmodul kann konfiguriert sein, Daten gemäß einem Standard wie IEEE 802.15.1 (Bluetooth®, insbesondere Bluetooth® Low Energy), IEEE 802.11 (Wireless Local Area Network -WLAN), ISO 14443, 18092, 21481 ECMA 340, 352, 356, 362, ETSI TS 102 190 (Near Field Communication - NFC) zu übertragen. Die Anzeigevorrichtung kann insbesondere als Modbus® RTU-Slave oder als CANopen®-Slave konfiguriert sein. Hierbei kann der Kontroller programmtechnisch derart konfiguriert sein, dass er Datenobjekte aufweist, die durch eine entsprechende Programmierung des vernetzten Steuerungssystems über das Bus-System beschrieben werden können, und dass er die beschriebenen Datenobjekte über die drahtlose Schnittstelle an ein zur Kommunikation mit der Anzeigevorrichtung konfiguriertes Gerät überträgt. Das mobile Kommunikationsgerät mit der drahtlosen Schnittstelle weist einen Prozessor auf, der programmtechnisch derart konfiguriert ist, dass das Kommunikationsgerät über die drahtlose Schnittstelle mit der Anzeigevorrichtung kommuniziert und Daten von der Anzeigevorrichtung empfängt und auf einem Bildschirm anzeigt.

Auf dem technischen Gebiet der Automatisierungstechnik wird häufig zur Anbindung intelligenter Sensoren und Aktoren ein unter dem Markennamen IO-Link bekanntes Kommunikationssystem eingesetzt, welches in der Norm IEC 61131-9 unter der Bezeichnung Single-drop digital communication interface for small sensors and actuators (SDCI) normiert ist. SDCI oder I/O-Link ist eine Punkt-zu-Punkt-Schnittstelle für den Anschluss beliebiger Sensorik und Aktuatorik, insbesondere von SDCI-Master oder I/O-Link-Master, SDCI-Slaves oder I/O-Link Devices an ein Steuerungssystem. Im Gegensatz zu klassischen Feldbussystemen erfolgt hierbei keine Busverdrahtung, sondern eine Parallelverdrahtung, wobei eine Punkt-zu-Punkt-Kommunikation ausgebildet wird. Die Standardisierung umfasst dabei sowohl die elektrischen Anschlussdaten als auch ein digitales Kommunikationsprotokoll (SDCI-Protokoll, insbesondere I/O-Link Protokoll) über das die Sensoren und Aktoren mit dem Automatisierungssystem in Datenaustausch treten. Der I/O-Link-Master stellt die Schnittstelle zur überlagerten speicherprogrammierbare Steuerung (SPS, englisch: Programmable Logic Controller, PLC) zur Verfügung und steuert die Kommunikation mit den angeschlossenen I/O-Link-Geräten, wobei der I/O-Link-Master einen oder mehrere I/O-Link-Ports haben kann und eine Offline-Parametrierung der I/O-Link-Geräte, insbesondere Sensoren vor dem Einbau erfolgen kann. Zudem wurde mit I/O-Link Wireless ein Standard erschaffen, welcher durch den Wegfall der Kabel wesentlich mehr Flexibilität, weniger Verschleiß und bessere Skalierbarkeit gegenüber der kabelgebundenen Alternative bietet. I/O-Link Wireless weist gegenüber anderen Funkprotokollen wie z.B. Bluetooth oder Zigbee eine deutlich geringere Fehlerwahrscheinlichkeit auf. Dank Abwärtskompatibilität müssen Anwender bei der Installation von I/O-Link Wireless ihr bestehendes I/O-Link System nicht austauschen, sondern können I/O-Link Wireless in ihr vorhandenes, kabelgebundenes System integrieren. Bei IO-Link Wireless können bis zu 40 Aktoren bzw. Sensoren mit einer maximalen Latenzzeit von 5ms an einen IO-Link Wireless Master angebunden werden. Insofern ist I/O-Link oder I/O-Link Wireless eine häufig benutzte Schnittstelle beim Industrie 4.0 (Internet of Things IoT)- Konzept.

Weiterhin ist aus der DE 10 2014 119 101 A1 eine Funktionsanschlusseinheit für den Anschluss von Funktionsmodulen entsprechen dem I/O-Link System bekannt, welche eine Mehrzahl von Funktionsmodulanschlüssen aufweist, an welche die Funktionsmodule für eine Kommunikation gemäß einem Kommunikationsprotokoll anschließbar sind. Weiterhin ist ein Parameterspeicher mit Parameterdaten zur gerätespezifischen Parametrisierung von zumindest einem Funktionsmodul vorgesehen, wobei der Parameterspeicher mit einem Funktionsmodulanschluss der Mehrzahl von Funktionsmodulanschlüssen verbindbar ist, und wobei die Funktionsanschlusseinheit ausgebildet ist, die Parameterdaten aus dem Parameterspeicher auszulesen und zumindest ein Funktionsmodul auf der Basis der ausgelesenen Parameterdaten gerätespezifisch zu parametrisieren. Die Parameterdaten ermöglichen eine gerätespezifische Parametrisierung bzw. Konfiguration der Funktionsmodule. Die Parameterdaten können beispielsweise technische Empfindlichkeiten, Schaltverzögerungen, Kennlinien oder Wertebereiche der Funktionsmodule angeben. Außerdem können die Parameterdaten Informationen zur Identifikation der Funktionsmodule, Prozess- und Diagnosedaten, Kommunikationseigenschaften und den Aufbau des Anwender-Interfaces in Engineering Tools angeben. Die Parameterdaten können in der Gestalt einer oder mehrerer Dateien vorliegen, z.B. einer Hauptdatei und einer optionalen externen Sprachdatei, beispielsweise in XML-Format. Die Parameterdaten können ferner Bilddateien im PNG-Format umfassen. Im Kontext der I/O-Link-Technologie können die Parameterdaten in einer I/ODD-Datei (I/O Device Description) vorliegen. Die Funktionsmodule sind beispielsweise Sensoren oder Aktoren gemäß der Norm IEC 61131 -9. Dadurch wird der technische Vorteil erreicht, dass zur Parametrierung der Funktionsmodule, beispielsweise Sensoren oder Aktoren, keine spezielle Serviceschnittstelle mehr vorgesehen sein muss. Außerdem ist zur Parametrierung der Funktionsmodule keine externe Kommunikationsverbindung, wie etwa ein Feldbus, notwendig. Bei dem Kommunikationsprotokoll kann es sich um ein Kommunikationsprotokoll gemäß I/O-Link oder "Single-Drop Digital Communication Interface for Small Sensors and Actuators (SDCI)" handeln. Der I/O-Link ist eine Punkt-zu-Punkt-Schnittstelle für den Funktionsmodulanschluss beliebiger Sensorik und Aktuatorik beispielsweise an ein Steuerungssystem. Gemäß SDCI wird eine Anbindung von Funktionsmodulen, wie z.B. Sensoren und/oder Aktoren in Übereinstimmung mit der Norm IEC 61131-9 durchgeführt. In einer vorteilhaften Ausführungsform ist die Funktionsanschlusseinheit ein Master gemäß dem SDCI-Protokoll, insbesondere ein I/O-Linkmaster. Somit ist eine Anbindung von intelligenten Funktionsmodulen, wie z.B. Sensoren und/oder Aktoren gemäß der Norm IEC 61131-9 möglich. Gemäß einer Ausführungsform ist die Schnittstelle als USB-Schnittstelle ausgebildet. Über die Schnittstelle kann der Speicher mit Daten beschrieben werden, beispielsweise mit Parameterdaten. Ferner kann der Parameterspeicher gemäß einer Ausführungsform ein Bedienelement aufweisen, das gemäß einer Ausführungsform als Taster ausgebildet ist. Gemäß einer Ausführungsform kann eine Übertragung der Parameterdaten von der Inbetriebnahmesoftware in die Funktionsanschlusseinheit durch Betätigen des Bedienelements ausgelöst werden. Nach dem Übertragen der Parameterdaten in die Funktionsanschlusseinheit kann der Parameterspeicher gemäß einer Ausführungsform in einem Speicherschreibmodus betrieben werden, während dessen der Speicher von der Funktionsanschlusseinheit mit Daten beschrieben wird. Um den Wechsel nach dem Übertragen der Funktionsmodulbeschreibungsdaten in die Funktionsanschlusseinheit in den Speicherschreibmodus aus einem sogenannten Transparentmodus zu bewirken, sendet die Funktionsanschlusseinheit ein Wake-Up-Signal an den Parameterspeicher. Somit wird nach der Übertragung der Parameterdaten in die Funktionsanschlusseinheit der Parameterspeicher in einem Speicherschreibmodus betrieben, während dem der Speicher von der Funktionsanschlusseinheit mit Daten beschrieben wird, so dass der Funktionsanschlusseinheit ein erweiterter Speicher während des Betriebs des Kommunikationssystems zur Verfügung steht.

Weiterhin ist aus der US 20100148591 A1 ein fernbedienbarer Einfach-Stecker mit einem Netzkabel zur Stromversorgung eines elektrischen Geräts bekannt. Solche Geräte im Haushalt sind beispielsweise ein Fernsehgerät, ein Computer, ein elektrischer Lüfter, ein Audiogerät, ein Videorecorder oder ein Klimagerät. In handelsüblicher Weise weist der Einfach-Stecker auf der einen Seite die Steckkontakte für die Netzsteckdose und auf der anderen Seite das Netzkabel zum jeweiligen Gerät auf. Zweck einer zugehörigen Fernbedienung zur Steuerung des Geräts, wobei diese einen Funk-Sender/Empfänger und optional nur einen Infrarotsender aufweist, ist es den Stand-by Betrieb des jeweiligen Geräts zu steuern, indem der fernbedienbare Einfach-Stecker die Stromversorgung des über das Netzkabel verbundenen Geräts unterbricht. In der Ausgestaltung mit einem Infrarotsender weist die Fernbedienung eine Modustaste für den HF - Übertragungsmodus oder den Infrarotübertragungsmodus auf. Alternativ kann auch ein Jog Shuttle mit Rad zur Steuerung des Energieverbrauchs durch Unterbrechung der Stromversorgung des jeweiligen Geräts vorgesehen sein.

Weiterhin ist aus der DE 10 2009 044 046 A1 ein Funk Adapter zur drahtlosen Verbindung einer in einem Schaltschrank angeordneten Automatisierungskomponente mit einem Netzwerk wie Ethernet oder einem mobilen Gerät wie Laptop, PDA oder Mobiltelefon, umfassend ein Gehäuse mit einer Antenne sowie einem Kommunikations-Interface bekannt, welches vorzugsweise über eine Verbindungsleitung mit der Automatisierungskomponente verbindbar ist. Im Einzelnen weist das Gehäuse einen zylinderförmigen Abschnitt auf, welcher mittels einer in einer Wandung des Schallschrankes montierbaren Kabelverschraubung innerhalb dieser fixierbar ist, wobei zumindest ein die Antenne aufweisender Abschnitt des Gehäuses außerhalb des Schaltschrankes angeordnet ist. Alternativ ist das Befestigungselement als eine Kabelverschraubung ausgebildet, und das Gehäuse weist einen zylinderförmigen Abschnitt auf, welcher mittels der in einer Wandung des Schaltschranks montierbaren Kabelverschraubung innerhalb dieser fixierbar ist. Insbesondere ist eine Montage des Gehäuses mittels der Kabelverschraubung in einer Schaltschrankwand als auch im Inneren des Schaltschranks mittels einer Kabelklemme möglich. Der Verbindungsanschluss, das Kommunikations-Interface, die Antenne sowie ggfs. Statusanzeigemittel können auf zumindest einer Leiterplatte angeordnet sein, welche in Längsrichtung in das Gehäuse einschiebbar und vorzugsweise über an einer Innenfläche des Gehäuses gegenüberliegend angeordnete Nuten fixiert ist.

Schließlich ist aus der DE 20 2009 009 066 U1 ein Automatisierungsgerät mit mindestens einer drahtlosen Kommunikationsschnittstelle zur Datenkommunikation mit weiteren Automatisierungsgeräten und/oder Feldgeräten, und mit einer Steuerelektronik bekannt, wobei die Steuerelektronik und eine Kommunikationsschnittstellenelektronik für die mindestens eine Kommunikationsschnittstelle auf einer in ein Gehäuse eingebrachten Leiterplatte angeordnet sind und in dem Gehäuse von außen zugängliche, mit der Kommunikationsschnittstellen- und/oder Steuerelektronik verbundene Steckverbinder zur Bereitstellung von Kommunikationsschnittstellen vorgesehen sind. Um eine gewünschte und erforderliche Abstrahlcharakteristik der Antenne sicherzustellen, ist mindestens ein mit Kommunikationsschnittstellenelektronik für eine drahtlose Kommunikationsschnittstelle verbundener Steckverbinder angrenzend an die Leiterplatte im Bereich der Kommunikationsschnittstellenelektronik ausgerichtet und hat einen zentrisch angeordneten Mittenkontakt für einen HF-Antennensignalanschluss und eine Mehrzahl, den zentrischen Mittenkontakt umgebende Außenkontakte für ein HF-Schirmpotential. Der mindestens eine Steckverbinder ist für eine jeweilige drahtlose Kommunikationsschnittstelle zur Aufnahme eines Antennensteckers vorgesehen und hat dem gleichen mechanischen Aufbau wie ein Steckverbinder, der für eine entsprechende drahtgebundene Kommunikationsschnittstelle in entsprechenden Automatisierungsgeräten genutzt wird und der kein Hochfrequenz-Antennenstecker ist. Dadurch, dass für den Antennenanschluss nicht spezialisierte Antennenstecker eingesetzt werden, sondern die gleichen auch für die drahtgebundene Kommunikationsschnittstelle genutzten Steckverbinder mit Mittenkontakt und diesen umgebenden Außenkontakten eingesetzt werden, kann die Gehäuse- und zugehörige Steckerkonstruktion von rein drahtgebundenen Automatisierungsgeräten und kombinierten drahtgebundenen und drahtlosen Automatisierungsgeräten gleich bleiben. Insbesondere wurde erkannt, dass sich die einen Mittenkontakt und diese umgebende Außenkontakte aufweisenden Standard-Steckverbinder auch zur HF-Übertragung eignen und für Automatisierungsgeräte ausreichende elektromagnetische Eigenschaften aufweisen, die eine Auskopplung von HF-Antennensignalen erlaubt. Die Nutzung solcher Standard-Steckverbinder für drahtgebundene Kommunikation gelingt insbesondere dadurch, dass der mindestens eine für die Bereitstellung einer drahtlosen Kommunikationsschnittstelle vorgesehene Steckverbinder angrenzend an die für die jeweilige drahtlose Kommunikationsschnittstelle vorgesehene Kommunikationsschnittstellenelektronik angeordnet ist. Auf diese Weise stellt die Kommunikationsschnittstellenelektronik der drahtlosen Kommunikationsschnittstelle einen Gegenpol für den Antennenstecker, d.h. den mit einem Antennenstecker vorgesehenen Steckverbinder bereit. Die Kommunikationsschnittstellenelektronik bildet zusammen mit dem angrenzenden Teil der Leiterplatte und dem Gehäuse somit neben dem Antennenstecker und der daran angeordneten Antenne oder Koaxialleitung einen Teil der wirksamen Antenne für die drahtlose Kommunikationsschnittstelle.

Wie die vorstehende Würdigung des Standes der Technik aufzeigt, sind unterschiedlich ausgestaltete Schnittstellen/Geräte seit langem bekannt, wobei diese für den jeweiligen speziellen Anwendungsfall, insbesondere auf dem Gebiet der Automatisierungstechnik ausgestaltet sind. Mit der Einführung von Industrie 4.0 kommt der Erfassung von Sensordaten eine wachsende Bedeutung zu. In der Regel werden - wie die vorstehende Würdigung des Standes der Technik aufzeigt - Sensoren (oder allgemein IO-Link Geräte) in der Anlage bzw. Maschine an dezentrale Ein-/Ausgangskomponenten angeschlossen, die diese mit der Steuerung oder direkt mit einer Cloud Applikation über ein standardisiertes Netzwerk verbinden. Dabei geht der Trend eindeutig zu einer schaltschranklosen Montage, was den Aufbau der Komponenten, insbesondere der IO-Link Geräte in IP65/67 und bei erhöhten Umgebungsanforderungen in Metall erfordern.

Diese Komponenten werden immer intelligenter, benötigen lokale Konfiguration und Diagnostik was im Stand der Technik über Kodierschalter oder Diagnosestecker mit leitungsgebundener Verbindung an Notebooks realisiert wird. Kodierschalter reichen bei weitem nicht mehr aus, Steckverbindungen in IP65/67 sind groß und aufwendig und auch Notebooks sind in diesem Umfeld schwer handhabbar.

Die optimale Lösung wäre eine funkgestützte Verbindung, bevorzugt mit Bluetooth und unter Einsatz von smarten Mobilgeräten wie Smartphones oder Tablets, wobei das Engineering Tool als App geladen werden kann (siehe vorstehende Würdigung des Standes der Technik).

Hierbei ergeben sich technische Probleme durch:
- Metallgehäuse lassen keine eingebaute Antenne zu.
- Bluetooth Integrationen auf Modullevel mit externer Antenne sind sehr aufwendig und schwierig in der Standardgehäusebreite von 30 mm einzubauen.
- Bluetooth Integration auf Chiplevel bedingt für jede Ein-/Ausgangskomponente eine individuelle Lösung verbunden mit einer aufwendigen Funkzertifizierung.
- Ein-/Ausgangskomponente mit permanenter Bluetooth Verbindung werden in Anlagen aus Sicherheitsgründen nicht akzeptiert.
- Eine aktive Bluetooth Kommunikation muss optisch angezeigt werden.
- Der Schnittstelleneinbau darf keine neuen Produktionsprozesse bedingen, sondern muss genauso einfach sein wie den üblicherweise eingesetzten M8-/M12-Steckverbinder.
- Die Schnittstellenkosten müssen im unteren einstelligen Eurobereich liegen.

Es fehlt somit seit langem eine Schnittstellenausgestaltung als Standardteil, welche Antenne und insbesondere Bluetooth Elektronik zusammen vereint und noch irgendwie manuell ein- und ausgeschaltet werden kann. Dieses Standardteil müsste einfach in die unterschiedlichsten Geräte, insbesondere IP67 IO-/IO-Link Geräte eingebaut werden können, damit man hohe Stückzahlen erreicht und die IP67 IO-/IO-Link Geräte und die daran angeschlossenen intelligenten IO-Link Sensoren oder intelligente IO-Link Aktuatoren oder IO-Link Geräte sollten unter Einhaltung entsprechender Sicherheitsbedingungen konfigurierbar sein.

Der Erfindung liegt die Aufgabe zugrunde, ausgehend von der aus der WO 2015/150402 A1 bekannten Anzeigevorrichtung mit einer drahtlosen Schnittstelle und mit einem manuellen Betätigungselement, ein Anschlussmodul als Standardteil derart auszugestalten, dass erhöhte Umgebungsanforderungen eingehalten werden und unter Benutzung einer funkgestützten Verbindung eine sichere lokale Schnittstellenaktivierung sowie Konfiguration und Diagnostik durchgeführt werden kann.

Diese Aufgabe wird, gemäß kennzeichnenden Teil des Patentanspruchs 1, dadurch gelöst, dass das Anschlussmodul ein zweiteiliges Gehäuse aufweist und in der Form eines Standard-Steckverbinders ausgestaltet ist, dass der nach der Montage im Gerät aus dem Gerätegehäuse des Geräts ragende erste Gehäuseteil durchsichtig ist und dass auf einem sich bis in den ersten Gehäuseteil erstreckenden Träger oder einer Leiterplatte eine Antenne des Funk-Sender/Empfängers und eine optische Schnittstelle zur Aktivierung und De-Aktivierung des Funk-Senders/Empfängers angeordnet sind.

Das erfindungsgemäße Anschlussmodul ist als drahtlose Schnittstelle wie ein Standard-Steckverbinder universell einsetzbar, so dass infolge der anpassbaren äußeren Form auch bestehende Schnittstellen umgerüstet werden können. Durch die auf optischen Weg bewirkte Ein-/Ausschaltung des Funk-Sender/Empfängers des Geräts erfolgt dies zielgerichtet und abhörsicher und das erfindungsgemäße Anschlussmodul löst auf überraschend einfache Art und Weise die vorgenannten Probleme.

In Ausgestaltung der Erfindung umfasst, gemäß Patentanspruch 2, die optische Schnittstelle sowohl einen Lichtsensor als optischer Empfänger als auch eine LED als optischer Sender, welche direkt an den Funk-Sender/Empfänger angeschlossen sind.

Diese Ausgestaltung der Erfindung weist den Vorteil auf, dass durch den direkten Anschluss von Fotosensor und LED an den Funk-Sender/Empfänger, dieser auch die Erkennung einer geeigneten Lichtimpulsfolge - welche die Bluetooth Sende- und Empfangsfunktion ein- und gegebenenfalls ausschaltet - übernimmt, sowie dessen Betrieb anzeigt.

In Weiterbildung der Erfindung ist, gemäß Patentanspruch 3, der erste Gehäuseteil als optisches Element mit oder ohne eine Linse ausgestaltet.

Diese Weiterbildung der Erfindung weist die Vorteile auf, dass durch die Ausgestaltung des optischen Elements mit einem geeigneten Kunststoff als Lightpipe, gleichzeitig der mechanische Schutz und die Halterung der eingebauten Antenne und Elektronik realisiert und eine IP65/67 Dichtigkeit erreicht wird.

Weitere Vorteile und Einzelheiten lassen sich der nachfolgenden Beschreibung von bevorzugten Ausführungsformen der Erfindung unter Bezugnahme auf die Zeichnungen entnehmen. In der Zeichnung zeigt:
- Fig. 1: das erfindungsgemäße Anschlussmodul in zwei Schnittansichten gemäß Schnittlinie A-B und Schnittlinie C-D,
- Fig. 2: einen Ausgestaltung der Schnittstelle mit handelsüblichen M8-Steckverbindern oder M12-Steckverbindern und mit erfindungsgemäßen Anschlussmodul und
- Fig. 3: eine schematische Darstellung der optischen Schnittstelle gemäß der Erfindung.

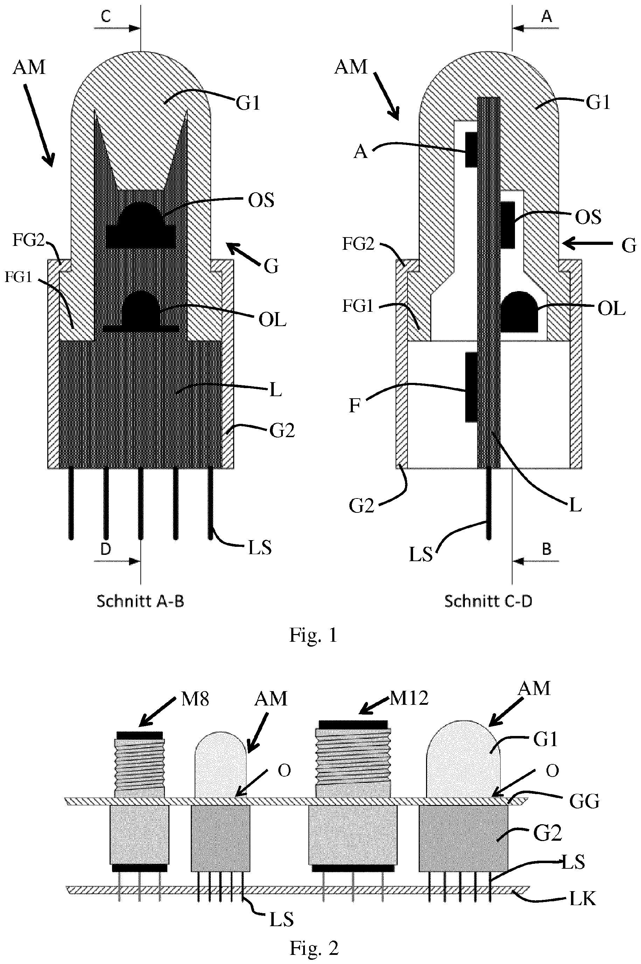

Gegenstand der Erfindung ist ein universelles Anschlussmodul AM als drahtlose Schnittstelle mit einem aktivierbaren und de-aktivierbaren FunkSender/Empfänger F zur Diagnose und Konfiguration von Geräten nach der Montage wie dies in Fig. 1 und Fig. 2 dargestellt ist.

Fig. 1 zeigt im Einzelnen die Ausgestaltung des erfindungsgemäßen Anschlussmoduls AM in der Form eines Standard-Steckverbinders mit einem zweiteiligen Gehäuse G, dessen nach der Montage im Gerät aus dem Gerätegehäuse GG des Geräts ragender erster Gehäuseteil G1 durchsichtig ist. Auf einem sich bis in den ersten Gehäuseteil G1 erstreckenden Träger oder einer Leiterplatte L sind eine Antenne A des Funk-Sender/Empfängers F und ein optische Schnittstelle O zur Aktivierung und De-Aktivierung des Funk-Senders/Empfängers F angeordnet.

Die Anschlüsse von IP65/67 Ein-/Ausgangskomponenten erfolgen, wie bei dem in Fig. 2 dargestellten Ausführungsbeispiel ersichtlich ist, durch standardisierte M8- oder M12 Steckverbinder. Diese werden in das Gehäuse G eingesetzt, anschließend mit der eingesetzten Leiterplatte L verlötet und die gesamte Einheit mit Epoxy (Epoxidharz, ein Kunstharz) vergossen, um eine IP65/67 Dichtigkeit zu erreichen. Das ungefüllte Harz ist transparent gelblich bis wasserklar und ist auch ultraviolettbeständig bzw. vergilbungsfrei erhältlich. Bei Wellenlängen <400nm wird Epoxidharz nahezu intransparent, im Infraroten ist es bis 2 µm transparent und der Brechungsindex liegt bei 1,5 bis 1,59.

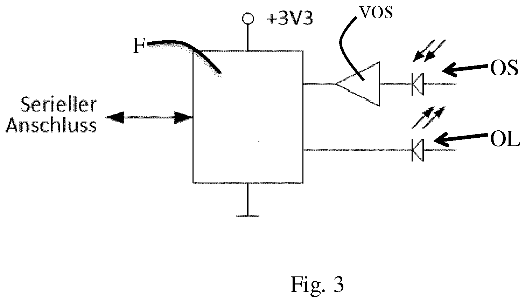

Die optische Schnittstelle O umfasst sowohl einen Lichtsensor OS als optischer Empfänger als auch eine LED OL als optischer Sender, welche direkt an den FunkSender/Empfänger F angeschlossen sind. Der erfindungsgemäße Standard-Steckverbinder AM mit optischer Ein-/Ausschaltung hat die gleichen Abmessungen (siehe Fig. 2), wird auf die gleiche Art und Weise verbaut und ist damit leicht in vorhandene Gerätegehäuse GG mit den bekannten Produktionsprozessen zu montieren. In Fig.3 ist eine schematische Darstellung der optischen Schnittstelle O, mit deren Komponenten Fotosensor/Lichtsensor OS und LED OL gemäß der Erfindung gezeigt, wobei der Fotosensor/Lichtsensor OS über einen Verstärker VOS (Verbesserung der Empfangsbedingungen) am FunkSender/Empfänger F angeschlossen ist.

Anstelle der bei standardisierten M8- oder M12 Steckverbinder vorhandenen mechanischen Steckkontakte erlaubt selbst die kleinere Bauform M8 des erfindungsgemäßen Standard-Steckverbinders AM den Einbau der gesamten Bluetooth Elektronik des Funk-Senders/Empfängers F einschließlich einer speziell auf die Anforderung ausgebildeten Antenne A. Dabei können die Lötkontakte zur Leiterplatte L in der gleichen Anzahl und Ausführung genutzt werden, da nur zwei Kontakte für die Stromzuführung und zwei bis vier weitere Kontakte ausreichen, um eine serielle Datenverbindung zwischen der Leiterplatte L und der Bluetooth Elektronik des Funk-Senders/Empfängers F mit den gängigen Schnittstellen wie I2C, SPI oder UART zu realisieren. Demzufolge erfolgt die Stromzuführung und die serielle Datenverbindung zwischen dem erfindungsgemäßen Standard-Steckverbinders AM auf und zu der zu montierenden Leiterkarte LK in vergleichbare Art- und Weise wie die bei den handelsüblichen Standard M8- und/oder M10- und/oder M12-Steckverbindern und es kann diesbezüglich auf die an sich bekannte Technik zurückgegriffen werden (M8 in den Polzahlen 3, 4, 5, 6 und 8 und M12 in den Polzahlen 3 bis 17).

Die M8- bzw. M12-Gewindeverbindung wird in ihrer Länge als Antenne A und optisches System O ausgebildet. Dazu ist der erste Gehäuseteil G1 mit einem geeigneten Kunststoff als Lichtleiter/Lightpipe ausgebildet, der gleichzeitig den mechanischen Schutz und die Halterung der eingebauten Antenne A und Elektronik bzw. der Leiterplatte L realisiert. Mit der Beschränkung auf die Länge der Gewindeverbindung, insbesondere der M8- und M12-Stecker ist die Antenne A außerhalb des zweiten Gehäuseteils G2 (Metallteil, insbesondere Hülse mit einem am Ende der Hülse umlaufenden Flansch FG2) und anderseits vergrößert nicht die Höhe der Ein-/Ausgangskomponente. Handelsübliche M8-Steckverbinder mit Federstifte LS als Anschlüsse für die Leiterkarte LK erstrecken sich 10mm vor der Geräte-Gehäusewand GG und 9mm innerhalb und haben vor der Geräte-Gehäusewand GG einen Durchmesser von 6mm (ist das erste Gehäuseteil G1 (Kegelförmiger Vorsatz (Raumform) beim erfindungsgemäßen Standard-Steckverbinders AM).

Bei der in Fig. 1 und Fig. 2 dargestellten Ausgestaltung sind im Innenraum des zweiten Gehäuseteils G2 der Funk-Senders/Empfänger F und die zugehörige Antenne A im Innenraum des ersten aus dem Gerät ragenden Gehäuseteil G1 angeordnet. Das zweite Gehäuseteil G2 ist bei diesem Ausführungsbeispiel als eine Hülse mit einem am Ende der Hülse umlaufenden Flansch FG2 ausgestaltet. Der erste Gehäuseteil G1 als ein im wesentlichen zylinderförmiges Kunststoffteil mit einer transparenten Gehäusehaube und an der gegenüberliegenden Seite mit einem umlaufenden Flansch FG1 ausgestaltet ist. Der Durchmesser des ersten Gehäuseteils G1 ist geringer als der Durchmesser des zweiten Gehäuseteils G2, wobei der Flansch FG1 des ersten Gehäuseteil G1 auf der Innenseite des Flansch FG2 des zweiten Gehäuseteils G2 anliegt. Nach der Montage des erfindungsgemäßen Anschlussmodul AM als drahtlose Schnittstelle (siehe Fig. 2) liegt die Außenseite des Flansch FG2 des zweiten Gehäuseteils G2 an der Innenseite der Geräte-Gehäusewand GG des Geräts an.

Die Lightpipe/erste Gehäuseteil G1 dient dazu einfallendes Licht auf den Lichtsensor OS, wie z.B. eine Fotodiode zu führen und ausgehendes Licht von der eingebauten LED OL lässt diese (beispielsweise blau) leuchten und zeigt damit eine aktive Bluetooth Verbindung des Funk-Sender/Empfängers F optisch an.

Fotosensor/Lichtsensor OS und LED OL der optischen Schnittstelle O sind direkt an einen Bluetooth Chip des Funk-Senders/Empfängers F angeschlossen. Der Fotosensor/Lichtsensor OS kann auch über einen Verstärker VOS Funk-Senders/Empfängers F angeschlossen sein. Dieser ist intelligent und übernimmt auch die Erkennung einer geeigneten Lichtimpulsfolge, welche die Bluetooth Sende- und Empfangsfunktion ein- und gegebenenfalls wieder ausschaltet, sowie dessen Betrieb anzeigt.

Für eine Paarbildung (Pairing) zwischen Funk-Sender/Empfänger F und Gerät wird vom Benutzer ein Identifizierungscode (Passwort) eingegeben und dieser abgespeichert. Vorzugsweise weist das Gerät einen am Gerätegehäuse GG angebrachten Barcode auf, welcher als Information einen bei der Paarbildung von Funk-Sender/Empfänger F und Gerät vom Benutzer gewählten Identifizierungscode enthält. Bei Benutzung eines smarten Mobilgeräts, wie Smartphone oder Tablet mit eingeladener Applikation (Software), als Bediengerät kann der Barcode (Strichcode gemäß European Article Number (EAN, IAN, JAN), Universal Product Code (UPC) oder 2D-Code, insbesondere QR-Code (Quick Response) oder gestapelter Barcode, Matrix-Code, Punktcode mit eingebetteter Information) mit einer Digitalkamera des Bediengeräts erfasst werden. Ein QR-Code besteht aus einer quadratischen Matrix aus schwarzen und weißen Punkten und Linien. Diese enthalten digital codiert die Informationen. In drei von vier Ecken ist ein Quadrat vorhanden, an dem sich der Scanner orientiert. Eine Applikation/Software des Bediengeräts ermöglicht es, die erfasste Code-Information des 2-dimensionalen Codes/Barcodes dem Anwender in dekodierter Form, also in Klartext, anzuzeigen. Durch Senden des Identifizierungscodes (Blinksequenz eines Pairing Code) mittels des optischen Senders OL wird über die optische Schnittstelle O auf überraschend einfache Art und Weise eine abhörsichere und gezielte Aktivierung und De-Aktivierung des FunkSender/Empfängers F /des Geräts ermöglicht. Bei Benutzung eines Bluetooth-Systems allein, würden alle im Funkempfangsbereich des Bluetooth-Senders befindlichen Geräte aktiviert werden. Insbesondere könnte der über die Funkstrecke übermittelte Identifizierungscode abgehört werden und eine normalerweise zum Aufbau einer Verbindung zwischen Bluetooth Sender und Empfänger vom Benutzer erneute manuelle Eingabe des Pairing Codes ist beim erfindungsgemäßen Anschlussmodul nicht erforderlich. Zur Datenübertragung zwischen den IO-Link-Geräten, insbesondere IO-Link-Sensoren kann IO-Link Wireless genutzt werden.

Im Rahmen der Erfindung kann die optische Schnittstelle O auch zur optischen Kommunikation (insbesondere bitseriellen Datenübertragung), einschließlich zur optischen Freiraumkommunikation (Halbleiterlaser mit einer Übertragungsrate von mehr als 1 Gbit/s) benutzt werden. Weiterhin kann ein Keramik-Chip für die Antenne A (eine oder mehrere Patchantennen, welche für sehr hohe Frequenzbänder geeignet sind, einen geringen dielektrischen Verlustwinkel aufweisen und als Schichtstruktur auf einen Keramikträger aufgebracht sind, wobei Keramik ein sehr guter Isolator und gegenüber Feuchtigkeit unempfindlich ist und wobei die Patchantenne auch eine Richtwirkung aufweisen kann; kombiniert mit einer hinter der Patchantenne liegenden und als Reflektor dienenden Metallfläche) im nicht abgeschirmten Teil des erfindungsgemäßen Standard-Steckverbinders AM benutzt werden.

### Bezugszeichenliste:

- A: Antenne
- AM: Anschlussmodul (Standard-Steckverbinder)
- F: Funk-Sender/Empfänger (Bluetooth, NFC, WLAN)
- G: Gehäuse
- FG1: Flansch (erstes Gehäuseteil)
- FG2: Flansch (zweites Gehäuseteil)
- G1: erster Gehäuseteil (optisches Element, Lichtleiter, light pipe)
- G2: zweiter Gehäuseteil (Metallteil)
- GG: Gerätegehäuse
- L: Leiterplatte
- LK: (Leiterkarte im Gerät)
- LS: Steckkontakte (Leiterplatte)
- O: optische Schnittstelle
- OL: LED (optische Schnittstelle, Sender)
- OS: Lichtsensor (Photosensor, optische Schnittstelle, Empfänger)
- VOS: Verstärker (Lichtsensor)

## Patentansprüche

1. Anschlussmodul mit einem aktivierbaren und de-aktivierbaren FunkSender/Empfänger (F) als drahtlose Schnittstelle zur Diagnose und Konfiguration des Geräts, **dadurch gekennzeichnet, dass** das Anschlussmodul ein zweiteiliges Gehäuse (G) aufweist und in der Form eines Standard-Steckverbinders (AM) ausgestaltet ist, dass der nach der Montage im Gerät aus dem Gerätegehäuse (GG) des Geräts ragende erste Gehäuseteil (G1) durchsichtig ist, und dass auf einem sich bis in den ersten Gehäuseteil (G1) erstreckenden Träger oder einer Leiterplatte (L) eine Antenne (A) des Funk-Sender/Empfängers (F) und eine optische Schnittstelle (O) zur Aktivierung und De-Aktivierung des Funk-Senders/Empfängers (F) angeordnet sind.

2. Anschlussmodul nach Anspruch 1, **dadurch gekennzeichnet, dass** die optische Schnittstelle (O) sowohl einen Lichtsensor (OS) als optischer Empfänger als auch eine LED (OL) als optischer Sender umfasst, welche direkt an den Funk-Sender/Empfänger (F) angeschlossen sind.

3. Anschlussmodul nach Anspruch 1 oder 2, **dadurch gekennzeichnet, dass** der erste Gehäuseteil (G1) als optisches Element mit oder ohne eine Linse ausgestaltet ist.

4. Anschlussmodul nach einem oder mehreren der Ansprüche 1 bis 3, **dadurch gekennzeichnet, dass** der Standard-Steckverbinder (AM) die Form und Abmessungen eines Standard M8- und/oder M12-Steckverbinders aufweist.

5. Anschlussmodul nach einem oder mehreren der Ansprüche 1 bis 4, **dadurch gekennzeichnet, dass** die Funk-Schnittstelle des Funk-Senders/Empfängers (F) als Bluetooth-Schnittstelle oder NFC-Schnittstelle oder WLAN-Schnittstelle ausgestaltet ist.

6. Anschlussmodul nach einem oder mehreren der Ansprüche 1 bis 5, **dadurch gekennzeichnet, dass** der zweite Gehäuseteil (G2) als ein Metallteil ausgestaltet ist und der Funk-Senders/Empfänger (F) im Innenraum des Metallteils angeordnet ist.

7. Anschlussmodul nach einem oder mehreren der Ansprüche 1 bis 6, **dadurch gekennzeichnet, dass** der zweite Gehäuseteil (G2) als eine Hülse mit einem am Ende der Hülse umlaufenden Flansch (FG2) ausgestaltet ist.

8. Anschlussmodul nach einem oder mehreren der Ansprüche 1 bis 7, **dadurch gekennzeichnet, dass** der erste Gehäuseteil (G1) als ein im wesentlichen zylinderförmiges Kunststoffteil mit einer transparenten Gehäusehaube und an der gegenüberliegenden Seite mit einem umlaufenden Flansch (FG1) ausgestaltet ist.

9. Anschlussmodul nach einem oder mehreren der Ansprüche 1 bis 8, **dadurch gekennzeichnet, dass** die Leiterplatte (L) auf der in das zweite Gehäuseteil (G2) erstreckenden Seite Steckkontakte (LS) zur Herstellung einer elektrischen und mechanischen Verbindung mit einer Leiterkarte (LK) im Gerät aufweist und dass in Erstreckungsrichtung der Leiterplatte (L) nach außerhalb des Gerätegehäuses (GG) der Funk-Sender/Empfänger (F), der optische Sender (OL), der optische Empfänger (OS) und die Antenne (A) angeordnet sind.

10. Anschlussmodul nach einem oder mehreren der Ansprüche 1 bis 9, **dadurch gekennzeichnet, dass** der Flansch des zweiten Gehäuseteils (G2) an der Innenseite des Gerätegehäuses (GG) anliegt und dass auf der gegenüberliegenden Seite der Flansch (FG1) des ersten Gehäuseteils (G1) anliegt.

11. Verfahren zur Aktivierung eines Funk-Senders/Empfängers für ein Anschlussmodul **gemäß Anspruch 1,** bei dem über eine in einem als Standard-Steckverbinder ausgestalteten Anschlussmodul (AM) angeordnete optische Schnittstelle (O) durch Eingabe eines Identifizierungscode an einem Bediengerät ein mit der optischen Schnittstelle in Verbindung stehender Funk-Sender/Empfänger (F) aktiviert und de-aktiviert wird.

12. Verfahren nach Anspruch 11, **dadurch gekennzeichnet, dass** das Anschlussmodul ohne Nutzung der optischen Schnittstelle (O) zur Datenübertragung durch IO-Link Wireless genutzt werden kann.

13. Verfahren nach Anspruch 11, **dadurch gekennzeichnet, dass** als Bediengerät ein mobiles Endgerät mit einem Infrarot-Sender und einem Funk-Senders/Empfängers benutzt wird.

14. Verfahren nach Anspruch 14, **dadurch gekennzeichnet, dass** das Gerät am Gerätegehäuse (GG) einen Barcode aufweist, welcher als Information einen bei einer Paarbildung von Funk-Sender/Empfänger (F) und Gerät vom Benutzer gewählten Identifizierungscode enthält.

15. Verfahren zur Herstellung eines Anschlussmoduls nach Anspruch 1, **dadurch gekennzeichnet, dass** die Anschlüsse von IP65/67 Ein-/Ausgangskomponenten durch standardisierte M8- oder M12 Steckverbinder des Anschlussmoduls (AM) erfolgen, die in das Gehäuse (G) eingesetzt werden, dass diese anschließend mit der eingesetzten Leiterplatte (L), auf welcher die Antenne (A), die optische Schnittstelle (O) und der FunkSender/Empfänger (F) angeordnet sind, verlötet werden und dass die gesamte Einheit mit einem aushärtbaren Kunstharz vergossen werden, derart, dass der erste Gehäuseteil (G1) als optisches Element mit oder ohne Linse ausgebildet ist und gleichzeitig den mechanischen Schutz und die Halterung der Leiterplatte (L) realisiert.

## Claims

1. A connection module with an activatable and deactivatable radio transceiver (F) as a wireless interface for diagnosis and configuration of the device, **whereby** the connection module has a two-part housing (G) and is designed in the shape of a standard connector (AM), whereby the first housing part (G1) protruding from the device housing (GG) of the device after installation in the device is transparent, and whereby an antenna (A) is provided on a carrier or a circuit board (L) extending into the first housing part (G1) of the radio transmitter / receiver (F) and an optical interface (O) for activating and deactivating the radio transceiver (F) are arranged.

2. Connection module according to Claim 1, **whereby** the optical interface (O) comprises both a light sensor (OS) as an optical receiver and an LED (OL) as an optical transmitter, which are connected directly to the radio transceiver (F).

3. Connection module according to Claim 1 or 2, **whereby** the first housing part (G1) is designed as an optical element with or without a lens.

4. Connection module according to one or more of Claims 1 to 3, **whereby** the standard plug connector (AM) has the shape and dimensions of a standard M8 and / or M12 plug connector.

5. Connection module according to one or more of Claims 1 to 4, **whereby** the radio interface of the radio transceiver (F) is designed as a Bluetooth interface or NFC interface or WLAN interface.

6. Connection module according to one or more of Claims 1 to 5, whereby the second housing part (G2) is designed as a metal part and the radio transceiver (F) is arranged in the interior of the metal part.

7. Connection module according to one or more of Claims 1 to 6, whereby the second housing part (G2) is designed as a sleeve with a flange (FG2) running around the end of the sleeve.

8. Connection module according to one or more of Claims 1 to 7, whereby the first housing part (G1) is designed as an essentially cylindrical plastic part with a transparent housing hood and on the opposite side with a circumferential flange (FG1).

9. Connection module according to one or more of Claims 1 to 8, **whereby** the circuit board (L) on the side extending into the second housing part (G2) has plug contacts (LS) for establishing an electrical and mechanical connection with a circuit card (LK) in the device and whereby the radio transceiver (F), the optical transmitter (OL), the optical receiver (OS) and the antenna (A) are arranged in the direction of extension of the printed circuit board (L) outside the device housing (GG).

10. Connection module according to one or more of Claims 1 to 9, **whereby** the flange of the second housing part (G2) rests against the inside of the device housing (GG) and **whereby** the flange (FG1) of the first housing part (G1) rests on the opposite side.

11. Method for activating a radio transmitter / receiver for a connection module according to Claim 1, **whereby** a radio transceiver (F) connected to the optical interface is activated and de-activated via an optical interface (O) arranged in a connection module (AM) designed as a standard plug connector by inputting an identification code on an operating device.

12. Method according to Claim 11, **whereby** the connection module can be used for data transmission by IO-Link wireless without using the optical interface (O).

13. Method according to Claim 11, **whereby** a mobile terminal with an infrared transmitter and a radio transmitter / receiver is used as the operating device.

14. Method according to Claim 14, **whereby** the device on the device housing (GG) has a barcode which contains, as information, an identification code selected by the user in the case of pairing of radio transmitter/receiver (F) and device.

15. Method for producing a connection module according to claim 1, **whereby** the connections of IP65/67 input/output components are connected by standardized M8 or M12 plug connectors of the connection module (AM) which are inserted into the housing (G) in such a way that they are subsequently soldered to the inserted circuit board (L) on which the antenna (A), the optical interface (O) and the radio transceiver (F) are arranged, and whereby the entire unit is cast with a curable synthetic resin in such a way that the first housing part (G1) is designed as an optical element with or without a lens and at the same time realizes the mechanical protection and the mounting of the printed circuit board (L).

## Revendications

1. Un module de connexion avec un émetteur-récepteur radio activable et désactivable (F) en tant qu'interface sans fil pour le diagnostic et la configuration du dispositif, le module de connexion ayant un boîtier en deux parties (G) et se présente sous la forme d'un connecteur standard (AM), la première partie de boîtier (G1) faisant saillie du boîtier de dispositif (GG) du dispositif après installation dans le dispositif étant transparente, et une antenne (A) étant disposée sur un support ou une carte de circuit (L) s'étendant dans la première partie de boîtier (G1) de l'émetteur/récepteur radio (F) et une interface optique (O) pour activer et désactiver l'émetteur-récepteur radio (F).

2. Le module de connexion selon la revendication 1, l'interface optique (O) comprenant à la fois un capteur de lumière (OS) en tant que récepteur optique et une LED (OL) en tant qu'émetteur optique, qui sont directement connectés à l'émetteur-récepteur radio (F).

3. Le module de connexion selon la revendication 1 ou 2, la première partie de boîtier (G1) étant réalisée sous la forme d'un élément optique avec ou sans lentille.

4. Le module de connexion selon une ou plusieurs des revendications 1 à 3, le connecteur mâle standard (AM) ayant la forme et les dimensions d'un connecteur mâle standard M8 et/ou M12.

5. Le module de connexion selon une ou plusieurs des revendications 1 à 4, moyennant quoi l'interface radio de l'émetteur-récepteur radio (F) est conçue sous la forme d'une interface Bluetooth ou d'une interface NFC ou d'une interface WLAN.

6. Le module de connexion selon une ou plusieurs des revendications 1 à 5, la deuxième partie de boîtier (G2) étant réalisée sous la forme d'une pièce métallique et l'émetteur-récepteur radio (F) étant disposé à l'intérieur de la pièce métallique.

7. Le module de connexion selon une ou plusieurs des revendications 1 à 6, la deuxième partie de boîtier (G2) étant réalisée sous la forme d'un manchon avec une bride (FG2) s'étendant autour de l'extrémité du manchon.

8. Le module de connexion selon une ou plusieurs des revendications 1 à 7, la première partie de boîtier (G1) étant réalisée sous la forme d'une pièce en matière plastique sensiblement cylindrique avec un capot de boîtier transparent et sur le côté opposé à une bride circonférentielle (FG1).

9. Le module de connexion selon une ou plusieurs revendications 1 à 8, la carte de circuit imprimé (L) sur le côté s'étendant dans la deuxième partie de boîtier (G2) présente des contacts de fiche (LS) pour établir une connexion électrique et mécanique avec une carte de circuit (LK) dans le dispositif et l'émetteur-récepteur radio (F), l'émetteur optique (OL), le récepteur optique (OS) et l'antenne (A) étant agencés dans la direction d'extension de la carte de circuit imprimé (L) à l'extérieur du boîtier de dispositif (GG).

10. Le module de connexion selon une ou plusieurs des revendications 1 à 9, moyennant quoi la bride de la seconde partie de boîtier (G2) repose contre l'intérieur du dispositif boîtier (GG), la bride (FG1) de la première partie de boîtier (G1) reposant sur le côté opposé.

11. Un procédé d'activation d'un émetteur/récepteur radio pour un module de connexion selon la revendication 1, dans lequel un émetteur-récepteur radio (F) connecté à l'interface optique est activé et désactivé par l'intermédiaire d'une interface optique (O) disposée dans un module de connexion (AM) réalisé sous la forme d'un connecteur mâle standard par introduction d'un code d'identification sur un dispositif d'exploitation.

12. Le procédé selon la revendication 11, dans lequel le module de connexion peut être utilisé sans utiliser l'interface optique (O) pour la transmission de données par radio-liaison sans fil.

13. Le procédé selon la revendication 11, dans lequel un terminal mobile avec un émetteur infrarouge et un émetteur/récepteur radio est utilisé en tant que dispositif de commande.

14. Le procédé selon la revendication 14, le dispositif sur le boîtier de dispositif (GG) comportant un code à barres qui contient, en tant qu'informations, un code d'identification sélectionné par l'utilisateur dans le cas de l'appariement de l'émetteur/récepteur radio (F) et du dispositif.

15. Un procédé de fabrication d'un module de raccordement selon la revendication 1, dans lequel les connexions des composants d'entrée/sortie IP65/67 sont reliées par des connecteurs mâles standardisés M8 ou M12 du module de connexion (AM) qui sont insérées dans le boîtier (G) de telle sorte qu'elles sont ensuite brasées à la carte de circuit imprimé insérée (L) sur laquelle sont disposées l'antenne (A), l'interface optique (O) et l'émetteur-récepteur radio (F), et la totalité de l'unité étant coulée avec une résine synthétique durcissable de telle sorte que la première partie de boîtier (G1) se présente sous la forme d'un élément optique avec ou sans lentille et réalise en même temps la protection mécanique et le montage de la carte de circuit imprimé (L).
